# EUROPEAN PATENT APPLICATION

(11) **EP 4 564 021 A1**
(43) Date of publication of application: **04.06.2025**
(21) Application number: 23213434.6
(22) Date of filing: 30.11.2023
(51) Int. Cl.: G01R 29/08

(54) **METHOD FOR ASSESSING ELECTROMAGNETIC COMPATIBILITY OF CABIN CONFIGURATIONS**

(71) Applicant: Airbus Operations GmbH, 21129 Hamburg (DE)
(72) Inventor: Weber, Lutz, 21129 Hamburg (DE); Großmann, Matthias, 21129 Hamburg (DE)

(57) **Abstract**

A method (M) for assessing electromagnetic compatibility (EMC) of an assembly of electronic components includes the steps of checking (M1) electronic components of the assembly of a plurality of electronic components as to which of the electronic components are considered to be compliant within the framework of the overall assembly EMC; finding (M2), for each electronic component of the subset of electronic components that have been found to be non-compliant, one or more replacement electronic components of a respective analogous component type that would be considered to be acceptable within the framework of the overall assembly EMC; testing (M3) an analogous assembly of the plurality of electronic components in which at least one of the subset of electronic components that have been found to be non-compliant has been virtually replaced by the respectively found replacement electronic component for overall assembly EMC of the analogous assembly; and assessing (M4) the assembly of the plurality of electronic components to be overall assembly EM compatible if the analogous assembly has been found to be overall assembly EM compatible in the testing step (M3).

## Description

### TECHNICAL FIELD OF THE INVENTION

The invention relates to a method for assessing electromagnetic compatibility (EMC) of components in a cabin configuration, for example in a cargo or passenger cabin of a transport vehicle, such as a passenger aircraft, a cargo aircraft, a helicopter, a passenger train, a road vehicle, a watercraft such as a ferry or a cruise ship or similar transport machines.

### TECHNICAL BACKGROUND

Ubiquitous use of computation, communication, automation and sensing equipment utilizing electronic circuitry in confined spaces on board of airborne, landborne and/or waterborne vehicles, such as for example passenger aircraft, cargo aircraft, helicopters, trains, ships, cars, or trucks, renders it necessary to operate electric circuitry elements at the same time in close proximity to each other. As such, electromagnetic interference (EMI) effects have become major drivers for challenges for equipment designers. The evolution of general purpose equipment, the downscaling of circuitry components, the widespread use of integrated circuitry as well as the encroachment of circuitry operating frequencies in more distant frequency domains increases both the probability and diversity of possible interferences among concurrently operated circuit elements in space-constrained environments.

In accordance with the standard IEC 60050-161:1990, electromagnetic compatibility (EMC) is defined as the ability of electronic systems to function properly and reliably in the intended electromagnetic (EM) environment without establishing a significant source of EM contamination to that same electromagnetic environment. Since electric energy in any EM environment consists of a conducted portion and a radiated portion, EMC must therefore be assessed in terms of susceptibility to conducted electric energy and capability or propensity to emit radiated EM energy.

Regulatory bodies thus adopted various EMC regulations that a product equipped with electronic systems needs to fulfil in order to be allowed to operate it in predefined EM environments. Such regulations define acceptable degrees of susceptibility and immunity to EMI and set upper limits of acceptable degrees of radiated emissions, often termed electromagnetic signature (EMS). The International Electrotechnical Commission (IEC) is the main standards regulator regarding EMC of technical systems in order to characterize the stability of a technical system with respect to the effects of various types of EMI on its interfaces to the EM environment, and the limiting values of EMI within such EM environments in the operating frequency bands of interest.

The document Gaynutdinov, R., & Chermoshencev, S. (2018): "Virtual Testing of Electronic Systems Susceptibility by Electromagnetic Compatibility Requirements", 2018 International Russian Automation Conference (RusAutoCon) discloses methods and means of electronic systems susceptibility virtual testing based on electromagnetic compatibility requirements, based on examples of aircraft equipment susceptibility virtual testing by the influence of radio-frequency electromagnetic fields.

The document Gomez, D. G., Garcia-Donoro, D., Rodriguez, P.L., Perez, H. G., and Acosta, L. D. (2020): "Optimized Aircraft EMC demonstration based on exploitation of Digitalized Data: EMC Matrix Tool," 2020 International Symposium on Electromagnetic Compatibility - EMC EUROPE, Rome, Italy, pp. 1-5 discloses an EMC matrix tool created to support the EMC design and EMC demonstration of aircraft electrical/electronical systems and installations. The tool is a software utility which processes digital data on equipment EMI qualification, functional architecture and electrical topology of any particular design in order to identify and predict possible EMI conflicts and weaknesses on installation.

### SUMMARY OF THE INVENTION

One of the objects of the invention is to find more efficient solutions for assessing the electromagnetic (EM) compatibility of assemblies of electronic components, specifically in confined spaces such as vehicles, for enabling the showing of compliance with EMC requirements.

This and other objects are achieved by means of a method for assessing electromagnetic compatibility (EMC) of an assembly of electronic components having the features of claim 1.

According to an aspect of the invention, a method for assessing electromagnetic compatibility (EMC) of an assembly of electronic components comprises steps of
- checking electronic components of the assembly of a plurality of electronic components as to which of the electronic components are considered to be compliant within the framework of the overall assembly EM compatibility,
- finding, for each electronic component of the subset of electronic components that have been found to be non-compliant, one or more replacement electronic components of a respective analogous component type that would be considered to be acceptable within the framework of the overall assembly EMC,
- testing an analogous assembly of the plurality of electronic components in which at least one of the subset of electronic components that have been found to be non-compliant has been virtually replaced by the respectively found replacement electronic component for overall assembly EMC of the analogous assembly, and
- assessing the assembly of the plurality of electronic components to be overall assembly EM compatible if the analogous assembly has been found to be overall assembly EM compatible in the testing step.

An important concept of the invention involves evaluation of the impact of non-compliant equipment that has not been assessed for EMC in the overall assembly against the background knowledge (data) of different overall assemblies that have previously been assessed for overall assembly EMC. Any non-compliant equipment will receive a positive flag and will be considered generally as overall assembly EM compatible if a statistically relevant number of other, previously checked assemblies in which the possibly non-compatible equipment has been replaced by equipment already checked for overall assembly EMC of the same or analogous equipment type which has been found to be overall assembly EM compatible.

The application of the method of the invention allows determining the compatibility of the assembly including one or more EM non-compatible equipment without having to perform individual EMC tests on assemblies containing the non-compatible equipment before assessing the assembly as overall EM compatible. This simplifies serial processes for EMC demonstration of each individual assembly, thereby reducing time and expenses needed during modification closure of e.g. aircraft cabin configurations.

Advantageous configurations and developments will emerge from the further dependent claims and from the description with reference to the figure. The advantageous configurations and developments may be combined with one another as desired where expedient. Further possible configurations, developments and implementations of the invention also encompass combinations, which are not explicitly mentioned, of features of the invention described above or below with regard to the exemplary embodiments. A person skilled in the art here will in particular also add individual aspects as improvements or additions to the respective basic form of the present invention.

### BRIEF SUMMARY OF THE DRAWINGS

The present invention will be discussed in more detail below on the basis of the exemplary embodiments shown in the schematic figures. In the figures:

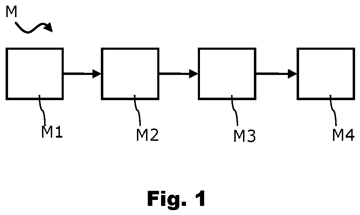

Fig. 1 shows a schematic flowchart of the steps of a method for assessing compliance of electromagnetic compatibility requirements of assemblies of electronic components according to some embodiments of the invention.

The appended figures are intended to provide improved understanding of the embodiments of the invention. They illustrate embodiments and serve, in conjunction with the description, for the explanation of principles and concepts of the invention. Other embodiments, and many of the stated advantages, will emerge with regard to the drawings. The elements of the drawings are not necessarily shown true to scale relative to one another. Direction-indicating terminology such as, for instance, "top", "bottom" "left", "right", "above" "below", "horizontal", "vertical", "front", "rear" and similar indications are used only for explanatory purposes and do not serve to restrict the generality to specific configurations as shown in the figures.

In the figures of the drawing, elements, features and components that are identical, functionally identical and of identical action are denoted in each case by the same reference signs unless stated otherwise.

### DESCRIPTION OF EXEMPLARY EMBODIMENTS

The following examples and embodiments are described in the context of assemblies of electronic components in cabin configurations of passenger aircraft, however, it should be noted that analogous consideration apply with respect to assemblies of electronic components in other transport vehicles, such as, but not limited to, cargo aircraft, helicopters, passenger trains, road vehicles, watercraft or similar transport machines.

Certain airworthiness regulations require EMC demonstrations in customized cabin configurations. Such customized cabin configurations within the meaning of the present disclosure include compositions of different electrical and/or electronic equipment, systems and subsystems which are provided by the aircraft manufacturer and/or aircraft equipment suppliers.

To achieve an EMC demonstration the main part of the process is to conduct an EMC analysis which may be obviated if all listed cabin equipment, systems and subsystems comply with all EMC requirements that have previously been verified by EMC equipment qualification. Such EMC equipment qualification is achieved through specific EMI tests or other regulatorily acceptable verification methods. In practice, if EM non-compatible equipment is contained in any cabin configuration extensive EMC is required to support the EMC demonstration process and to avoid further EMI aircraft testing.

During EMC analysis a predefined number of parameter measurement results, for example radiated emissions, electromagnetic emission signatures or similar, are investigated with regard to specification compliance set out in airworthiness regulations. Each piece of equipment or cabin system has a unique EM signature that is typically measured in dBµV/m in frequency ranges of interest, such as from several tens of MHz up to several GHz. The measured unique EM signatures of each piece of equipment or cabin system are then superimposed leading to a total EM signature equating to the EM signature of the cabin configuration. The number of EM non-compatible equipment is taken into account in the calculations of the total EM signature of the cabin configuration, so that the unique total EM signature of the cabin configuration may be checked with respect to possible EM impacts, in general proving a non-zero noise margin with regard to the respectively set system limit.

Currently, with a newly composed cabin configuration all EMC relevant equipment and systems are analysed for adherence to EMC regulations. Particularly, EM non-compatible equipment or systems are analysed repeatedly in every altered cabin configuration with respect to its contribution to the total EM signature of this cabin configuration, rendering the EMC check of each new cabin configuration cumbersome and time-consuming.

Fig. 1 shows a schematic flowchart of the steps of a method M for assessing compliance of electromagnetic compatibility (EMC) requirements of assemblies of electronic components according to some embodiments of the invention. The method M is a statistical method using measurement results and an adequate number of previously determined cabin configurations from a configuration library. The method M may advantageously be performed at a final phase of equipment qualification and before the first practical application or implementation of the cabin configuration in a customized setting.

In a first stage M1, electronic components of an assembly of a plurality of electronic components are checked as to which of the electronic components are considered to be compliant within the framework of the overall assembly EMC. In a second stage M2, for each electronic component of the subset of electronic components that have been found to be non-compliant in the first stage M1, one or more replacement electronic components of a respective analogous component type that would be considered to be acceptable within the framework of the overall assembly EMC are found. In a third stage M3, an analogous assembly of the plurality of electronic components in which at least one of the subset of electronic components that have been found to be non-compliant has been virtually replaced by the respectively found replacement electronic component is tested for overall assembly EMC of the analogous assembly. In a fourth stage M4, the assembly of the plurality of electronic components is assessed to be overall assembly EM compatible if the analogous assembly has been found to be overall assembly EM compatible in the third stage M3. Within the fourth stage M4, the component measurement results for radiated emissions will be superimposed including the analogous measurement results of the replacement EM compatible electronic components to generate analogous EM signatures of the analogous assemblies. These analogous EM signatures are then used in lieu of the real EM signatures of the assembly under assessment to determine overall assembly EMC.

That way, equipment considered to be potentially incompatible in terms of EMC requirements may be flagged as being EM compatible within the framework of the assessed assembly by virtue of having been virtually checked for EMC against a statistically adequate number of replacement components that have previously been checked for EMC themselves.

The third stage M3 may be iterated with an adequate number of type replacements for each of the determined EM non-compatible electronic components, and in the fourth stage M4, the assembly of the plurality of electronic components is assessed to be overall assembly EM compatible only if each of the analogous assemblies has been found to be overall assembly EM compatible in every iteration of the third stage M3.

In the first stage M1, it may be possible to assume overall assembly EMC compliance if the electronic components are considered to be acceptable within the framework of the overall assembly EMC in a limited number of pre-determined frequency ranges, for example frequency ranges used by navigation, communication and/or surveillance systems on board of the aircraft.

In the second stage M2, for the subset of electronic components that are considered to be compliant within the framework of the overall assembly EMC in the first stage M1, an adequate analogous subset of electronic components of analogous component types as each of the EMC non-compatible electronic components in the determined subset is found. The analogous subset may as a set have previously been determined to be acceptable within the framework of the overall assembly EMC.

In order to improve the stringency of the representation, various features were combined in one or more examples in the detailed description above. However, it should be clear in this case that the description above is only of an illustrative and in no way restrictive nature. It is used to cover all alternatives, modifications and equivalents of the various features and exemplary embodiments. Many other examples will be immediately and directly clear to a person skilled in the art on the basis of his technical knowledge in view of the description above.

The exemplary embodiments were chosen and described in order to be able to represent the principles on which the invention is based and their possible uses in practice in the best possible manner. As a result, experts may optimally modify and use the invention and its various exemplary embodiments for the intended purpose. In the claims and the description, the terms "containing" and "having" are used as neutral concepts for the corresponding term "comprising". Furthermore, use of the terms "a", "an" and "one" is not intended to fundamentally exclude a plurality of features and components described in such a way.

## Claims

1. Method (M) for assessing electromagnetic compatibility, EMC, of an assembly of electronic components, the method (M) comprising:
checking (M1) electronic components of the assembly of a plurality of electronic components as to which of the electronic components are considered to be compliant within the framework of the overall assembly EMC;
finding (M2), for each electronic component of the subset of electronic components that have been found to be non-compliant, one or more replacement electronic components of a respective analogous component type that would be considered to be acceptable within the framework of the overall assembly EMC;
testing (M3) an analogous assembly of the plurality of electronic components in which at least one of the subset of electronic components that have been found to be non-compliant has been virtually replaced by the respectively found replacement electronic component for overall assembly EMC of the analogous assembly; and
assessing (M4) the assembly of the plurality of electronic components to be overall assembly EM compatible if the analogous assembly has been found to be overall assembly EM compatible in the testing step (M3).

2. Method (M) according to claim 1, wherein the assembly of electronic components is a configuration of cabin equipment in the passenger cabin of a passenger aircraft.

3. Method (M) according to claim 2, wherein overall assembly EMC is assumed in the checking step (M1) if the electronic components are considered to be acceptable within the framework of the overall assembly EMC in a limited number of pre-determined frequency ranges.

4. Method (M) according to claim 3, wherein the pre-determined frequency ranges include at least one of frequency ranges used by navigation, frequency ranges used by communication, and frequency ranges used by surveillance systems on board of an aircraft.

5. Method (M) according to one of claims 1 to 4, wherein the testing step (M3) is iterated with an adequate number of type replacements for each of the determined EM non-compatible electronic components.

6. Method (M) according to claim 5, wherein the assembly of the plurality of electronic components is assessed to be overall assembly EM compatible only if each of the analogous assemblies has been found to be overall assembly EM compatible in every iteration of the testing step (M3).

7. Method (M) according to one of claims 1 to 6, wherein for the subset of electronic components that are considered to be compliant within the framework of the overall assembly EMC in the checking step (M1) an adequate analogous subset of electronic components of analogous component types as each of the EM non-compatible electronic components in the determined subset is found in the finding step (M2).

8. Method (M) according to claim 7, wherein the analogous subset as a set has previously been determined to be acceptable within the framework of the overall assembly EMC.
